## Europäisches Patentamt
## European Patent Office
## Office européen des brevets

(19)

(11) Numéro de publication: **0 051 525**
.B1

(12)

# FASCICULE DE BREVET EUROPEEN

(45) Date de publication du fascicule du brevet:
15.02.84

(51) Int. Cl.³: **H 03 K 19/177**

(21) Numéro de dépôt: 81401683.8

(22) Date de dépôt: 23.10.81

(54) Réseau logique intégré à programmation électrique simplifiée.

(30) Priorité: 03.11.80 FR 8023463

(43) Date de publication de la demande:
12.05.82 Bulletin 82/19

(45) Mention de la délivrance du brevet:
15.02.84 Bulletin 84/7

(84) Etats contractants désignés:
DE FR GB IT NL

(56) Documents cités:
US - A - 4 094 012
US - A - 4 130 900

ELECTRONIC DESIGN, VOLUME 18, 1ER SEPTEMBRE
1975, ROCHELLE PARK (US), N. CAVLAN et al.
"Field-PLAs simplify logic designs", pages 84-90

(73) Titulaire: SOCIETE POUR L'ETUDE ET LA FABRICATION
DE CIRCUITS INTEGRES SPECIAUX - E.F.C.I.S.,
17, avenue des Martyrs, F-38100 Grenoble (FR)

(72) Inventeur: Brice, Jean-Michel, THOMSON-CSF
SCPI 173, bld Haussmann, F-75360 Paris Cedex 08 (FR)

(74) Mandataire: Guérin, Michel et al, THOMSON-CSF
SCPI 173, Bld Haussmann, F-75379 Paris Cédex 08 (FR)

Réseau logique intégré à programmation électrique simplifiée

La présente invention concerne les réseaux logiques programmables, c'est-à-dire des circuits intégrés possédant n entrées de signaux logiques et m sorties, et capables de fournir sur chacune des sorties une combinaison logique particulière, programmée, des signaux binaires appliqués sur les entrées. Cette combinaison logique s'exprime sous forme d'une somme logique de plusieurs produits logiques des signaux d'entrée.

Dans le cas général, un réseau logique programmable possède deux matrices de portes, à savoir:

– d'une part une matrice produit qui consiste en une série de p portes logiques de 2n entrées chacune; ces entrées sont couplées à certaines des n entrées Ai, complémentées ou non du réseau, et les sorties des portes fournissent des signaux qui sont des produits des variables d'entrée a, reçues; on désigne ces produits par le terme «produits intermédiaires»; ils sont au nombre de p s'il y a p portes; cette matrice produit s'appelle généralement matrice ET et les portes sont des portes ET ou réalisent l'équivalent logique d'une fonction ET;

– d'autre part une matrice somme ou matrice OU qui consiste en une série de m portes (autant que de sorties du réseau, c'est-à-dire que de combinaisons logiques différentes à réaliser); ces portes sont des portes OU, ou en réalisent l'équivalent logique; elles ont chacune p entrées couplées respectivement à certaines des sorties de p portes ET de la matrice ET; les sorties des m portes OU fournissent des sommes logiques des signaux appliqués à leurs entrées, c'est-à-dire des sommes des produits des variables d'entrée.

Ces sorties sont les sorties du réseau.

Le but de la programmation du réseau est de faire en sorte que chaque sortie définisse une combinaison particulière choisie des variables d'entrée, exprimée sous forme d'une somme de produits de certaines de ces variables.

On peut faire ici une parenthèse pour indiquer que le raisonnement serait identique si on inversait les positions des matrices OU et ET pour réaliser en sortie des combinaisons logiques exprimées sous forme de produits de sommes. L'algèbre de Boole montre qu'une telle inversion est possible sans difficultés, et on se contentera de décrire l'invention pour des sommes de produits.

La programmation du réseau consiste donc à définir la matrice ET pour obtenir des produits de certaines variables d'entrée, et à définir la matrice OU pour obtenir des sommes de certains des produits réalisés.

Par exemple, pour obtenir les combinaisons

$S_1 = \bar{a}_1 a_2 a_3 + a_1 \bar{a}_2$
et $S_2 = a_1 a_3 + a_1 \bar{a}_2$
dans un réseau à trois entrées et deux sorties, il faut:

1. réaliser une porte ET recevant $\bar{a}_1$, $a_2$ et $a_3$, une autre recevant $a_1$ et $\bar{a}_2$ et une troisième recevant $a_1$ et $a_3$.

2. réaliser une porte OU recevant la sortie des première et deuxième portes ET, et une autre recevant la sortie des deuxième et troisième portes ET.

Avant programmation, les portes ET de la matrice ET peuvent recevoir toutes les entrées de variables $a_i$ et leurs compléments; après programmation elles ne reçoivent que les variables sélectionnées pour faire un produit particulier; les autres doivent être déconnectées pour qu'il n'y ait pas d'influence, sur un produit particulier, d'une variable $a_i$ n'apparaissant pas dans ce produit.

De même, les portes OU de la matrice OU peuvent recevoir avant programmation toutes les sorties des portes ET, c'est-à-dire qu'elles peuvent additionner tous les p produits intermédiaires calculés par la matrice ET; après programmation, une porte OU correspoondant à une sortie du réseau ne doit recevoir sur ses entrées que les produits intermédiaires apparaissant dans la combinaison logique à réaliser sur cette sortie; les sorties des autres portes ET, correspondant à des produits ne devant pas apparaître dans la somme, doivent être déconnectées.

La présente invention s'intéresse aux réseaux qui sont programmables électriquement par l'utilisateur et non à ceux qui sont programmés en fabrication par des techniques de masquage.

Le problème à résoudre est le suivant: la programmation électrique du réseau nécessite d'avoir un accès électrique individuel à toutes les entrées des portes ET et des portes OU, au total à $2n \times p$ entrées de portes ET ajoutées à $p \times m$ entrées de portes OU. Par exemple, on peut avoir 8 entrées se décomposant en 16 avec leurs compléments, 8 sorties et 64 produits intermédiaires (les nombres n, m et p sont indépendants et déterminent la capacité globale du réseau). Ces chiffres correspondent à 1536 points de programmation à effectuer. Chacun de ces points doit être accessible individuellement pour appliquer un signal de programmation adéquat (par exemple une tension électrique capable de détruire un fusible en série avec une diode dans une réalisation particulièrement simple).

La programmation vue du côté de l'utilisateur consiste à sélectionner les entrées de portes qui doivent recevoir un signal de neutralisation, à leur appliquer ce signal, et à laisser les autres entrées actives.

S'il y a un nombre de points de programmation aussi élevé que 1536, on peut prévoir que 11 entrées binaires ($2^{11} = 2048$) serviront à désigner chacune des portes à travers un décodeur, pour diriger exclusivement vers la porte désignée le signal de programmation. Il est impératif, pour des raisons de minimisation du nombre de broches de connexions extérieures du circuit intégré, que ces entrées soient prises parmi les broches existant obligatoirement sur le circuit intégré, par exemple les broches correspondant aux entrées $A_o$ et $A_{n-1}$ et aux sorties $S_o$ à $S_{m-1}$, ces broches n'ayant alors pas la même fonction en mode normal de calcul logique et en mode exceptionnel de programmation (une entrée spéciale pouvant définir le mode).

Pour l'opérateur, le problème est le suivant, il faut:

– qu'il établisse les formules des diverses combinaisons logiques à réaliser (les diverses sommes de produits des variables d'entrée $a_i$); et qu'il affecte à chacune une sortie du réseau, c'est-à-dire une porte OU déterminée;

– qu'il établisse une liste de tous les produits intermédiaires apparaissant dans les diverses combinaisons logiques; et qu'il affecte une porte ET à chacun d'eux;

– qu'il détermine, pour un produit particulier donc pour une porte ET respective, quelles sont les entrées de cette porte ET à neutraliser, compte tenu de la correspondance entre les entrées $a_i$ du réseau et les entrées des portes ET; cette correspondance est directe puisque chaque entrée $A_i$ du réseau est connectée à une entrée respective de toutes les portes ET;

– qu'il prévoie, avant de passer en programmation, l'adressage de chacune des entrées à neutraliser, compte tenu de la correspondance prévue par le fabricant, entre les entrées d'adressage et les entrées des portes ET à neutraliser; mais cette fois, même si ce sont les entrées $A_i$, c'est-à-dire les entrées de variables, qui servent aussi d'entrées d'adressage en mode programmation, la correspondance n'est plus du tout directe; elle se fait à travers un codage binaire à cause du grand nombre ($2n \times p$) de points de programmation à adresser dans la matrice ET;

– après avoir fait ces opérations et programmé toute la matrice ET, il faut encore que l'opérateur détermine, pour une combinaison logique particulière à réaliser, donc pour une porte OU respective, quelles sont les entrées de cette porte OU qu'il faut neutraliser, compte tenu de la correspondance entre la liste des produits intermédiaires qu'il a établie et les positions d'entrées de porte OU connectées aux sorties de produits intermédiaires;

– enfin, il faut que l'opérateur prévoie, avant de passer en programmation de la matrice OU, l'adressage de chacune des entrées de porte OU à neutraliser, compte-tenu de la correspondance prévue par le fabricant, en mode de programmation, entre les entrées d'adressage et les entrées de porte OU à déconnecter; cette correspondance est évidemment encore tout à fait indirecte et l'utilisateur doit en connaître le codage binaire; si ce sont encore les entrées de variable $a_i$ qui servent d'entrées d'adressage de la matrice OU en mode de programmation, cela fait une correspondance de plus à connaître pour le programmeur entre les numéros de broches extérieures du réseau et la structure interne de celui-ci.

Un exemple de réseau logique programmable utilisant ce principe est le circuit IM5200 de la société INTERSIL qui est programmable électriquement; dans ce circuit, deux des entrées de variable $A_i$ servent à définir le passage en mode de programmation, quatre sorties du réseau servent, en mode de programmation, à désigner des secteurs de matrice ET et OU à programmer, et neuf entrées de variables servent, en mode de programmation, à désigner les entrées de portes à déconnecter.

Le travail très important du programmeur peut se justifier car il s'agit d'un réseau non reprogrammable. Toutefois, il serait souhaitable, même dans ce cas, de réduire ce travail; il est de toutes façons nécessaire d'y parvenir si le réseau est effaçable et reprogrammable électriquement, faute de quoi l'intérêt de la reprogrammation disparaîtrait devant la difficulté de celle-ci.

Tel est le but que cherche à atteindre la présente invention en proposant un réseau logique programmable – qui présente une grande facilité d'utilisation lors de la programmation, – qui permet en particulier de programmer simultanément la matrice ET et la matrice OU contrairement à ce qui se faisait jusqu'à maintenant, – qui permet l'utilisation directe des entrées de variables $A_i$ avec une signification commune en mode de lecture et en mode de programmation de la matrice ET, – qui de préférence ne nécessite pas de broches de connexion supplémentaires pour l'adressage des entrées des portes de la matrice ET et de la matrice OU en mode de programmation, – qui permet un test après programmation pour la vérification individuelle soit de la programmation de chaque porte ET ou OU, soit même de celle de chaque entrée de porte ET ou OU, avec une grande facilité d'adressage des portes ou entrées à tester, – qui permet aussi, dans le cas du test de la programmation de chaque porte, d'effectuer simultanément le test de la matrice ET et de la matrice OU.

Pour cela, l'invention propose un réseau logique programmable caractérisé par le fait qu'il comporte un décodeur capable de désigner individuellement chacune des colonnes de sortie de la matrice produit ainsi qu'une ligne d'entrée de la matrice somme correspondant au même produit intermédiaire que la colonne désignée, un circuit logique d'interface de liaison entre lesdites matrices, apte à engendrer, à partir du signal de sortie du décodeur et de signaux de commande d'écriture d'un circuit de commande, des signaux de programmation de la colonne désignée et de la ligne correspondante de la matrice somme, le réseau comprenant encore un circuit d'interface d'entrée pour engendrer, à partir de signaux d'écriture appliqués sur les entrées de variables et des signaux de commande d'écriture du circuit de commande, des signaux de programmation de lignes de la matrice produit, ces signaux étant tels que le produit intermédiaire obtenu en sortie de la colonne désignée en mode de lecture, après programmation par les signaux de programmation de lignes et de colonne, soit un produit des variables correspondant aux entrées de variables sur lesquelles on a appliqué un signal d'écriture particulier.

Autrement dit, le décodeur désigne un produit intermédiaire particulier, et les entrées de variable Ai sont utilisées en programmation, pour établir ce produit intermédiaire, avec la même signification qu'en utilisation normale. On lit directement sur le produit intermédiaire à réaliser quelles sont les entrées de variable Ai auxquelles il faut appliquer un signal d'écriture particulier.

Selon une autre caractéristique de l'invention, il est prévu aussi un circuit d'interface de sortie apte à engendrer, à partir de signaux d'écriture appliqués aux sorties du réseau utilisées comme entrées et de signaux de commande d'écriture du circuit de commande, des signaux de programmation des colonnes de la matrice somme, ces signaux étant tels que le produit intermédiaire désigné par le décodeur apparaisse en mode de lecture sur celles des sorties sur lesquelles on a appliqué un signal d'écriture particulier lors de la programmation.

Autrement dit, une fois encore, le travail du programmeur est simplifié car, sachant que le produit intermédiaire désigné par le décodeur doit apparaître sur telle et telle sortie du réseau, on appliquera un signal d'écriture particulier à ces sorties (utilisées en entrées mais conservant pour le programmeur la même signification). On voit donc que l'invention évite dans une très large mesure la partie fastidieuse du travail de programmation puisque les entrées de variable gardent la même signification qu'on soit en mode de lecture ou en mode de programmation et de plus les sorties du réseau correspondent aussi aux mêmes portes OU en mode de lecture et en mode de programmation.

C'est ainsi par exemple que pour programmer le produit $a_i a_j a_k$ devant apparaître dans plusieurs sommes de produits $S_q$, $S_r$ et $S_s$, on désignera à l'aide des entrées d'adressage (mode programmation) la porte ET qui doit réaliser ce produit; on appliquera un signal d'écriture particulier aux entrées de variable Ai, Aj et Ak (alors que dans la technique antérieure on l'aurait appliqué à des bornes tout à fait différentes); en même temps, on appliquera un signal de programmation de porte OU justement aux sorties $S_q$, $S_r$ et $S_s$ qui doivent engendrer le produit $a_i$ $a_j$ $a_k$, en laissant les autres sorties inactives.

Ce mode de programmation est donc extrêmement simple pour l'utilisateur qui, dans l'exemple numérique déjà utilisé, se voit épargner la nécessité de connaître une correspondance (binaire) entre onze entrées d'adressage et 1536 entrées de portes à programmer.

Il a maintenant à connaître la correspondance faite par le décodeur selon l'invention entre six entrées d'adressage ($2^6 = 64$) et les p (64) portes ET, le reste de la détermination des signaux de programmation à effectuer se faisant par une application d'informations aux entrées de variable Ai et aux sorties de fonction Si avec une correspondance directe et immédiate entre les combinaisons logiques à réaliser et les signaux de programmation à appliquer.

On doit cependant, tout en gardant le principe ainsi expliqué, avec ses avantages, tenir compte de deux facteurs de complication qui sont rendus nécessaires (ici comme d'ailleurs dans la technique antérieure) pour ne pas augmenter le nombre de broches de connexions extérieures du circuit intégré.

Le premier facteur de complication vient de ce qu'on désire utiliser seulement n broches d'entrée de variables Ai alors que les combinaisons logiques à réaliser par le réseau peuvent comprendre soit ces variables $a_i$ soit leurs compléments $\bar{a}_i$. En lecture, il n'y a pas de difficulté car on introduit une information à deux états: présence de $a_i$ ou de son complément, et des signaux binaires 0 ou 1 appliqués aux n entrées $a_i$ suffisent à préciser complètement l'information d'entrée.

Mais, en mode de programmation, il faut être capable d'introduire pour chaque variable $a_i$ une information à trois états, car un produit à réaliser sur une porte ET peut

– comprendre la variable $a_i$ parmi d'autres
– ou comprendre son complément $\bar{a}_i$
– ou ne comprendre ni $a_i$ ni $\bar{a}_i$ mais seulement d'autres variables.

Cette information à trois états ne peut être obtenue par la seule introduction d'un signal binaire d'écriture sur les entrées Ai comme le décodeur selon l'invention inviterait à le faire. Il faudrait alors dédoubler les entrées Ai pour pouvoir introduire pour chaque variable $a_i$, les trois possibilités ci-dessus (information à deux chiffres binaires).

On veut éviter ce dédoublage des broches de connexion qui ferait perdre à l'invention une grande partie de son intérêt (on aurait la simplification de programmation aux prix de n broches supplémentaires, ce qui est difficilement acceptable).

Le deuxième facteur de complication vient de ce qu'on désire éviter d'avoir des broches d'entrée supplémentaires pour effectuer, en mode de programmation, l'adressage du décodeur. On ne peut a priori utiliser directement les entrées Ai puisqu'on veut qu'elles servent, en programmation, à diriger les signaux de programmation sur les entrées appropriées des portes ET; on ne peut pas non plus a priori utiliser les sorties Si du réseau logique puisqu'on veut qu'elles servent, en programmation, à diriger les signaux de programmation sur les portes OU appropriées. On verra cependant que l'invention permet quand même d'adopter cette dernière solution.

Pour résoudre ces deux problèmes simultanément, tout en gardant une grande simplification de la programmation, la présente invention propose d'effectuer chaque étape de programmation en deux temps, ce qui permet:

– d'introduire sur chaque entrée Ai comme signal d'écriture deux informations binaires successives que l'on mémorise pendant l'étape de programmation, ces deux informations indépendantes permettant de choisir, par un codage extrêmement simple et parlant pour le programmeur, entre les trois possibilités de programmation de chaque variable dans un produit (occurence de la variable, occurence de son complément, non-occurence); c'est le circuit d'interface d'entrée qui établit trois types de signaux de programmation correspondants;

– d'introduire sur les sorties Si, fonctionnant d'abord en entrées d'adressage supplémentaires sur le circuit intégré, une adresse binaire désignant une porte ET; cette adresse est gardée en mémoire par le circuit d'interface de sortie; puis, dans le deuxième temps de l'étape de programmation, on introduit les signaux d'écriture particulier sur les sorties Si fonctionnant en entrées de données de programmation correspondant directement aux portes OU à programmer.

Cette procédure d'écriture en deux temps pour chaque produit intermédiaire peut être réalisée grâce à la fonction de verrouillage des circuits d'interface d'entrée et sortie.

Comme les sorties Si jouent un rôle de sorties et un rôle d'entrées, on interpose entre chaque colonne de sortie de la matrice somme et la sortie Si correspondante un amplificateur à trois états dont le troisième état est commandé par le circuit de commande.

De préférence le circuit d'interface d'entrée aiguille la première partie du signal d'écriture appliqué à une entrée de variable Ai vers une ligne d'entrée de la matrice produit correspondant à cette variable Ai, et il aiguille la deuxième partie vers la ligne d'entrée correspondant au complément Ai de cette variable.

Pour que la grande simplification de programmation apportée par l'invention garde sa valeur, il faut que le codage des informations introduites en deux temps sur les entrées Ai soit très simple et parlant pour l'opérateur. On a donc cherché à se rapprocher le plus possible du code binaire existant sur ces entrées en mode lecture, en effet, en lecture 1 sur Ai indique la présence de Ai, et un 0 sur Ai indique la présence de $\bar{a}_i$; on a donc choisi, en mode de programmation en deux temps, – d'introduire comme signal d'écriture deux fois de suite un 1 sur Ai si le produit à programmer contient $a_i$, – d'introduire deux fois de suite un 0 sur Ai si le produit à programmer contient $\bar{a}_i$, – d'introduire une fois un 1 et une fois un 0 sur Ai si le produit à programmer ne doit contenir ni $a_i$ ni $\bar{a}_i$.

Parmi les avantages de l'invention, on peut encore signaler que les opérations de test des matrices programmées se font avec la même simplification que les opérations de programmation; le test se fait d'ailleurs simultanément pour les deux matrices qui restent indépendantes en test comme en programmation. Pour cela, le circuit logique d'interface de liaison entre matrices est apte à engendrer, à partir du signal de sortie du décodeur désignant un produit intermédiaire particulier et de signaux de commande de test venant du circuit de commande, un signal de résultat de test du produit intermédiaire désigné, ce signal étant transmis à une sortie de lecture de test. Quant au circuit d'interface d'entrée, il est apte à engendrer, à partir de signaux logiques de test appliqués sur les entrées de variable et de signaux de commande de test du circuit de commande, des signaux de test de lignes de la matrice produit, appliqués aux lignes d'entrées de cette matrice de telle manière qu'il y ait correspondance directe entre l'application d'un signal de test particulier sur chaque entrée de variable et l'application d'un signal de test de ligne sur une ligne de la matrice produit correspondant à cette variable.

Là encore, l'invention permet d'effectuer le test de programmation en gardant aux entrées de variable la même signification qu'elles ont en lecture (et en écriture).

Le test peut se faire entrée de porte par entrée de porte pour vérifier la neutralisation de chaque connexion, ou plus globalement porte par porte.

Les signaux de test appliqués aux entrées de variable Ai peuvent être exactement les mêmes que les signaux d'écriture particulier: signaux à deux informations successives introduites en deux temps, deux 1 successifs sur Ai produisant un signal de test de ligne sur une ligne de matrice correspondant à la variable $a_i$, deux 0 successifs produisent un signal de test de ligne sur une ligne correspondant à $\bar{a}_i$, et un 1 et un 0 produisant simultanément un signal de test sur les lignes $a_i$ et $\bar{a}_i$. Le circuit d'interface d'entrée fonctionne donc exactement de la même manière en écriture et en test.

Par contre, le circuit d'interface de sortie, qui permet d'effectuer le test de la matrice somme, ne fonctionne pas de la même manière en écriture et en test.

En mode de test, les sorties Si sont encore utilisées dans un premier temps d'une étape de test pour effectuer l'adressage du décodeur et désigner un produit intermédiaire. Le circuit d'interface de liaison entre matrices engendre, à partir du signal du décodeur et de signaux de commande de test venant du circuit de commande, un signal de test de ligne appliqué à la ligne d'entrée de la matrice somme désignée par le décodeur. Pendant que le circuit d'interface de sortie garde en mémoire l'adressage du décodeur, les sorties Si du réseau fonctionnent alors, dans un deuxième temps d'une étape de test, comme sorties des portes de la matrice somme, et fournissent le résultat du test avec une correspondance directe entre le niveau logique obtenu sur chaque sortie et la présence effective du produit intermédiaire désigné dans la combinaison logique programmée correspondant à cette sortie.

On notera que cette utilisation du décodeur et d'un test en deux temps permet de tester simultanément la matrice produit et la matrice somme.

On a mentionné jusqu'ici le rôle des circuits d'interface en écriture et en test. En utilisation normale du réseau, c'est-à-dire en mode de lecture, le circuit d'interface d'entrée transmet les signaux logiques apparaissant sur les entrées Ai d'une part directement vers une ligne de la matrice produit et d'autre part après inversion vers une ligne voisine. Le circuit d'interface de sortie transmet directement les sorties des colonnes de la matrice somme vers les sorties Si respectives. Le circuit d'interface de liaison entre matrices relie la sortie de chaque colonne de matrice produit à une ligne d'entrée respective de la matrice somme.

Dans un mode de réalisation préférentiel de l'invention, on utilise des transistors à effet de champ du type MNOS (métal – nitrure – oxyde – semiconducteur) pour programmer la connexion de chaque entrée de variable à une entrée de porte ET respective, ou la connexion de chaque sortie de porte ET à une entrée de porte OU respective.

Un transistor MNOS présente la possibilité, remarquable pour réaliser une programmation électrique effaçable, de pouvoir être rendu non conducteur de manière permanente par application sur sa grille de commande d'une haute tension qui réalise un piégeage d'électrons à l'interface entre la couche de nitrure et la couche d'oxyde. Les électrons piégés restent prisonniers de cet interface lorsque la haute tension disparaît et ils maintiennent le transistor MNOS bloqué; l'application ultérieure sur la grille de commande d'une tension qui normalement rendrait le transistor conducteur n'a maintenant plus d'effet sur lui.

Ce piégeage peut aussi être effacé électriquement par application d'une haute tension en sens inverse.

Les transistors n'ayant pas été soumis à la haute tension de piégeage se comportent normalement en transistors c'est-à-dire qu'ils peuvent être bloqués ou rendus conducteurs selon la tension appliquée à leur grille.

Cette propriété des transistors MNOS est utilisée particulièrement économiquement (en nombre de transistors utilisés pour une porte) si on réalise les portes ET et OU sous la forme de portes NOR (NON-OU). Il est en effet équivalent du point de vue logique d'utiliser à la place d'une porte ET à n entrées une porte NOR à n entrées avec un inverseur en amont de chaque entrée. De même, une porte OU est une porte NOR suivie d'un inverseur. On continuera dans la suite à parler de porte OU et ET pour désigner leur fonction globale, en sachant qu'elles sont réalisées à partir de portes NOR.

L'intérêt d'utiliser des portes NOR est que ces portes peuvent comprendre uniquement des transistors MNOS en parallèle, un par entrée de porte, les grilles de commande servant d'entrées, les sources étant à la masse et tous les drains (reliés entre eux et constituant la sortie de la porte NOR) étant reliés à une tension positive à travers une charge commune.

Il découle de cette structure que chaque porte NOR comprend plusieurs entrées indépendantes qui sont les grilles des transistors, une connexion de liaison des drains entre eux, une connexion de liaison des sources entre elles et une connexion de tension d'alimentation. On peut y ajouter une connexion de liaison des substrats de transistors entre eux.

Par ces cinq connexions on peut, – en mode de lecture, polariser les transistors de manière adéquate pour qu'ils réalisent la fonction NOR, – en mode de programmation (effacement d'abord puis écriture), appliquer sur les connexions les tensions adéquates autorisant le «piégeage» ou non des transistors.

L'application des polarisations ou tensions de programmation adéquates est effectuée par les circuits d'interface d'entrée, de sortie, et de liaison, sous la commande du circuit de commande. Les signaux de programmation ou de test engendrés par ces circuits sont constitués par des configurations déterminées de tension aux électrodes des transistors MNOS (tension nulle ou normale ou élevée ou liaison haute impédance).

D'autres caractéristiques et avantages de l'invention apparaîtront à la lecture de la description détaillée qui suit et qui est faite en référence aux dessins annexés dans lesquels:

– la fig. 1 montre le schéma global extrêmement simplifié d'un réseau logique programmable
– la fig. 2 en montre l'équivalent réalisé avec des portes NOR
– la fig. 3 montre une porte NOR réalisée à l'aide de transistors MNOS
– la fig. 4 montre un schéma bloc de la structure de réseau selon la caractéristique essentielle de l'invention
– la fig. 5 représente le bloc du circuit logique de commande du réseau
– la fig. 6 représente le circuit d'interface de liaison entre matrices
– la fig. 7 représente le circuit d'interface d'entrée
– la fig. 8 représente le diagramme temporel des signaux déterminant la décomposition en deux temps de la programmation ou du test
– la fig. 9 représente le circuit d'interface de sortie
– la fig. 10 représente un circuit de production d'un résultat de test de la matrice ET et de production d'une tension de protection des drains des transistors MNOS.

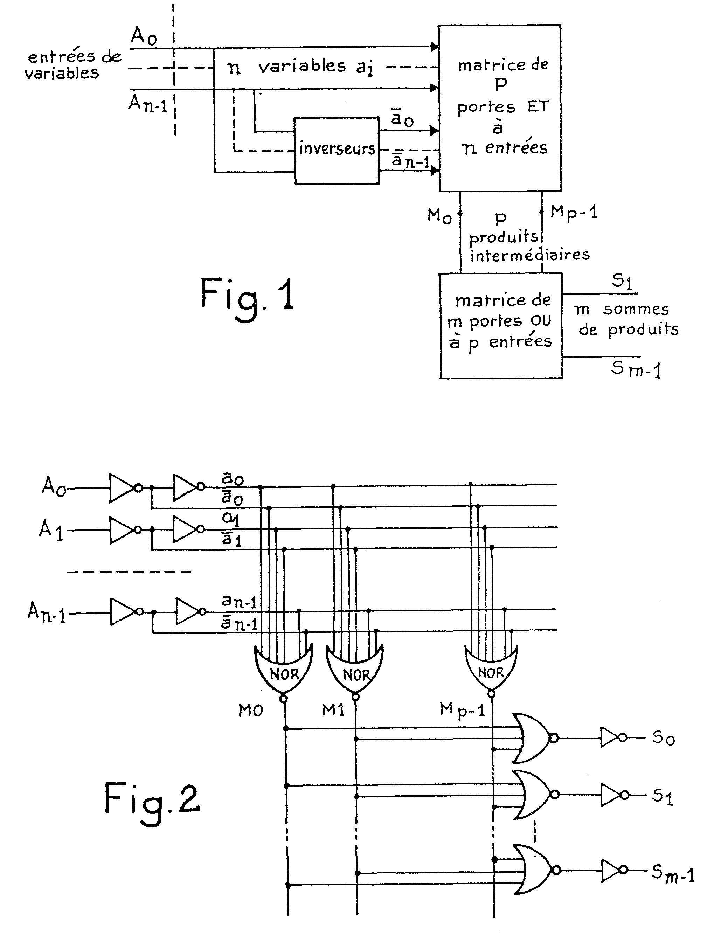

On voit à la fig. 1 le schéma de principe d'un réseau logique programmable: à partir de n entrées de variables Ao à An-1 on peut introduire des signaux logiques $a_o$ – $a_{n-1}$ et leurs compléments $\bar{a}_o$ à $\bar{a}_{n-1}$ sur 2 n lignes d'entrées d'une matrice de portes ET (p portes ET à 2 n entrées chacune) qui fournit à sa sortie des produits logiques intermédiaires Mo à Mp-1 des variables d'entrée $a_i$ (directes ou complémentées). Chacun des produits intermédiaires est déterminé par celles des variables d'entrée ou de leurs compléments qui sont effectivement couplées aux entrées de porte ET.

Les produits intermédiaires Mi constituent à la fois des colonnes de sortie de la matrice ET et des lignes d'entrée d'une matrice de portes OU (m portes OU à p entrées chacune) qui fournit, sur ses colonnes de sortie So à Sm-1, des combinaisons logiques des variables d'entrée $a_o$ à $a_{n-1}$ sous forme de sommes de produits intermédiaires des variables. Chacune des sommes est déterminée par le couplage effectif entre certaines colonnes de produits intermédiaires et les entrées de la porte OU correspondant à cette somme.

La programmation du réseau pour obtenir sur chacune des sorties la combinaison logique désirée consiste à sélectionner les connexions à réaliser entre les entrées de variable et les portes ET, ainsi qu'entre les sorties de la matrice ET et les entrées de portes OU.

La fig. 2 montre un réseau logique équivalent à celui de la fig. 1 mais où les matrices produit et somme (matrices ET et OU) sont réalisées avec des portes NOR (NON-OU). Une porte ET peut en effet se remplacer par une porte NOR dont chaque entrée est précédée d'un inverseur; une porte OU par une porte NOR suivie d'un inverseur. On pourrait aussi n'utiliser que des OU et inverseurs.

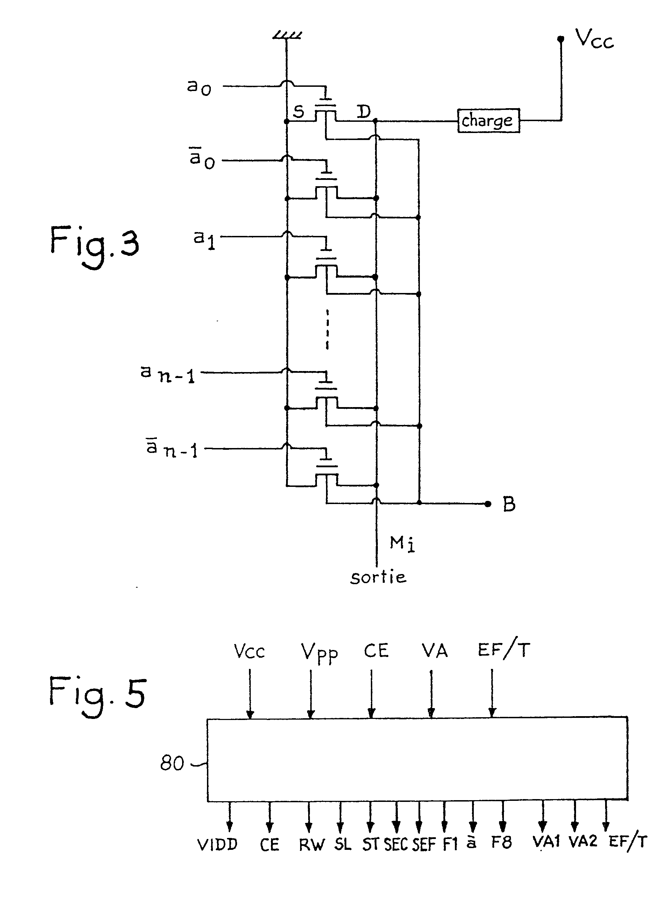

La fig. 3 montre un exemple de porte NOR à n entrées $a_o$, $a_1$ ... $a_{n-1}$, réalisée à l'aide de transistors à effet de champ. Il s'agit ici de transistors MNOS (métal-nitrure-oxyde-semiconducteur) à canal N. Il pourrait s'agir d'autres types de transistors sans sortir du cadre de l'invention, mais ceux-ci sont particulièrement appropriés pour une programmation électrique du réseau.

Pour jouer le rôle d'une porte NOR, les sources des transistors sont toutes réunies et reliées à la masse, les drains sont tous réunis et reliés à une charge commune connectée à une tension d'alimentation normale Vcc. Les substrats sont tous reliés à une tension commune, en principe de 0 volt.

Chaque grille de commande de transistor sert d'entrée à la porte NOR et la sortie est prise sur les drains réunis. Les signaux logiques $a_o$, $\bar{a}_o$, $a_1$, $\bar{a}_1$ ..., $\bar{a}_{n-1}$ servent à bloquer ou débloquer les transistors. La mise en conduction d'un ou plusieurs transistors par un signal logique de niveau 1 (quelques volts positifs sur la grille), met à zéro la sortie. Le blocage de tous les transistors simultanément met à 1 la sortie. Il s'agit donc bien d'une porte NOR.

La programmation de la porte consiste à supprimer ou mettre en blocage permanent les transistors correspondant aux variables qui ne doivent pas influer sur la sortie; par exemple, réaliser en sortie le produit $a_i \bar{a}_j$ consiste à supprimer ou bloquer tous les transistors reliés aux autres entrées que $\bar{a}_i$ et $a_j$; de même, réaliser la somme $a_i + \bar{a}_j$ consisterait à ne conserver comme transistors actifs que ceux reliés aux entrées $a_i$ et $\bar{a}_j$.

On conçoit qu'on ne sortirait pas du cadre de l'invention en adoptant une autre structure de porte NOR ou OU, par exemple en utilisant la source des transistors comme sortie avec une charge en série avec la source et le drain à une tension fixe.

Le choix de transistors MNOS comme éléments des portes est particulièrement avantageux car il offre une possibilité commode de programmation électrique pour neutraliser l'influence d'une entrée de porte NOR sur sa sortie.

Cette neutralisation se fait par la mise en état de blocage permanent du transistor MNOS par piégeage d'électrons à l'interface de ses deux couches d'oxyde; les électrons piégés maintiennent la tension de seuil du transistor à une valeur haute (environ 7 V) et créent un seuil de tension de déblocage que ne peut franchir un signal logique normal (0 à 5 V) appliqué à la grille. Les transistors non «piégés» sont conducteurs ou bloqués selon leur tension de grille car leur tension de seuil est basse: 1 à 2 volts.

Le piégeage se fait par application d'une forte tension sur la grille (environ 25 volts). Il est non destructif et réversible: on peut évacuer les électrons piégés vers le substrat par application d'une forte tension sur celui-ci. Il s'agit alors d'un effacement électrique de la programmation, tous les transistors revenant dans leur état normal.

On peut déjà indiquer, avant de décrire le schéma-bloc du réseau selon l'invention, le tableau des valeurs de tension à appliquer aux différentes connexions électriques de la porte NOR à transistors MNOS pour

– l'utilisation du réseau dans sa fonction normale (mode de lecture)
– l'effacement d'une programmation (mode d'effacement)
– la programmation de nouvelles fonctions du réseau (mode d'écriture)

1. Lecture
– Sources à 0 volt
– Dains reliés à la charge
– Charge reliée à Vcc = environ 5 volts
– Substrat à zéro
– Grilles recevant les signaux logiques des entrées de variable pour la matrice ET et les sorties de portes de la matrice ET pour la matrice OU
– Sortie sur les drains réunis

2. Effacement
– Sources déconnectées (état haute impédance)
– Drains déconnectés (état haute impédance)
– Grilles reliées à la masse
– Substrats reliés à une haute tension Vpp ~ 25 volts

3. Ecriture
a) Transistors à bloquer
– Sources déconnectées
– Drains à 0 volt
– Substrat – 0 volt
– Grilles à haute tension

b) Transistors à garder actifs
– Sources déconnectées
– Drains à 0 volt

– Substrat à 0 volt
– Grilles à 0 volt

c) Colonnes de transistors à protéger pendant qu'une colonne particulière est programmée
– Sources déconnectées
– Drains à une tension de protection Vp élevée
– Substrat à 0 volt
– Grilles quelconques

On remarquera que ces modes d'application de tension pour l'écriture permettent de programmer colonne par colonne chaque matrice de portes NOR puisque l'application d'une tension de protection Vp aux drains protège les colonnes correspondantes sans empêcher l'application de tensions de grille quelconques à tous les transistors de la matrice.

Chaque matrice sera constituée de la manière suivante:

– toutes les sources des transistors MNOS sont reliées entre elles par colonnes pour qu'une colonne de source puisse être mise à la masse ou en l'air;
– tous les drains sont reliés entre eux par colonnes pour que chaque colonne de drains puisse être, indépendamment des autres, reliés à une charge ou à la masse ou à une tension de protection Vp, ou être mise en l'air;
– toutes les grilles sont reliées entre elles par lignes de la matrice pour que chaque ligne puisse être, indépendamment des autres, reliée à une tension nulle ou normale (en lecture et en test), ou à une tension nulle ou élevée (en écriture)
– tous les substrats sont reliés entre eux et à un conducteur de commande qui peut les mettre à une tension nulle (cas général) ou élevée (en effacement).

Le rôle des circuits d'interface du réseau sera d'appliquer les tensions appropriées sur les lignes de grille, les colonnes de source et de drains, et les substrats réunis, en fonction de signaux de mode de fonctionnement (lecture, effacement, écriture, test) et en fonction des signaux logiques appliqués aux diverses entrées du réseau, y compris les sorties utilisées comme entrées.

Ayant ainsi expliqué le principe structurel de base du réseau logique programmable électriquement selon l'invention, on va maintenant décrire le schéma-bloc du réseau permettant essentiellement de réaliser la programmation sous la forme simple expliquée dans le préambule de la présente demande de brevet.

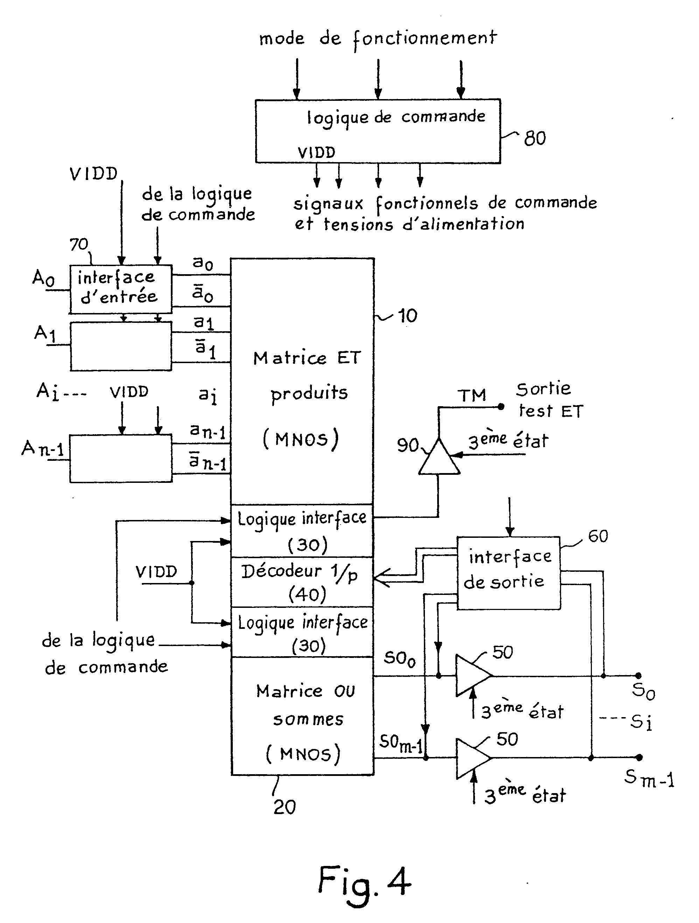

Ce schéma-bloc est représenté à la fig. 4. On y voit encore une matrice produit ET (10) avec ses 2 n entrées de variables $a_o$, $\bar{a}_o$ à $a_{n-1}$, $\bar{a}_{n-1}$, et une matrice OU (20) à base de transistors MNOS. La liaison entre elles n'est pas directe, elle se fait à travers un circuit logique d'interface (30) qui a pour rôles essentiels:

– d'une part de rétablir la liaison directe entre matrice ET et matrice OU en mode de lecture
– d'autre part d'établir, en mode d'effacement, en mode d'écriture (et aussi en mode de test lorsqu'on veut pouvoir vérifier la programmation du réseau), les connexions adéquates permettant l'application des niveaux de tension souhaités sur les colonnes de drains et sources des transistors de la matrice ET, sur les lignes de grille de la matrice OU, et sur les substrats des transistors des deux matrices.

Selon la caractéristique essentielle de l'invention, un décodeur (40) est prévu, apte à désigner individuellement chacune des colonnes de sortie de la matrice ET ainsi que la ligne d'entrée de la matrice OU correspondant au même produit intermédiaire que la colonne de sortie désignée.

Cette désignation est destinée au circuit logique d'interface qui réalise l'application des tensions convenables à la colonne et à la ligne désignée.

Le décodeur est constitué par exemple simplement par une série de p portes ET ou NOR qui reçoivent des adresses binaires servant à la désignation de la colonne choisie et qui ont des entrées programmées (de manière définitive) pour que chaque adresse possible ouvre une et une seule porte parmi les p portes du décodeur.

Le décodeur sert en mode d'écriture surtout mais également en mode de test.

Les adresses binaires qu'il reçoit sont amenées par des broches de connexion extérieures à l'aide desquelles l'utilisateur choisit la colonne de transistors à programmer dans la matrice ET. Ces broches sont, par souci de réduction du nombre de broches extérieures, de préférence choisies parmi des broches utilisées à d'autres fins en mode de lecture. Elles ne sont cependant pas prises parmi les broches d'entrées de variables Ao à An-1 qui servent à un autre usage pendant la programmation.

Dans l'exemple préférentiel décrit, les entrées d'adressage du décodeur en mode d'écriture sont prises parmi les sorties So à Sm-1 du réseau, qui fonctionnent alors en entrées. Il y a besoin en réalité d'un nombre r d'entrées d'adressage du décodeur tel que $2^{r-1} < p \leqslant 2^r$; par exemple, si le réseau comprend 64 produits intermédiaires, on pourra utiliser 6 entrées d'adressage choisies parmi les sorties So à Sm-1. Ce sont ces r entrées, dédoublées en 2 X r avec leurs compléments logiques qui sont appliquées aux p portes constituant le décodeur.

Pour que les sorties So à Sm-1 puissent fonctionner en sorties des portes OU de la matrice OU, et aussi en entrées pour le décodeur, on interpose entre les sorties de porte OU et les bornes Si des amplificateurs tampons (50) à trois états, avec une commande de troisième état isolant les sorties Si des sorties SOi de la matrice OU. La mise dans le troisième état est effectuée en mode d'écriture et est supprimée en mode de lecture. En mode de test, on verra qu'elle est utilisée partiellement.

Les bornes de sortie Si (So à Sm-1) sont donc raccordées aux entrées du décodeur, mais par l'intermédiaire d'un circuit d'interface de sortie (60) ayant notamment un rôle de verrouillage et d'aiguillage car on veut, en mode d'écriture, utiliser les sorties Si non seulement comme entrées d'adressage du décodeur (dans un premier temps de l'écriture), mais aussi dans un deuxième temps comme entrées d'écriture proprement dite par lesquelles on peut désigner ceux des transistors MNOS de la matrice OU qui doivent être bloqués (le décodeur indiquant seulement à quelle ligne d'entrée de la matrice OU on s'intéresse au cours d'une étape de programmation).

Le circuit d'interface de sortie (60) est là pour garder en mémoire l'adressage du décodeur pendant qu'on introduit sur les bornes Si les données d'écriture qui sont dirigées vers les sorties SOi des portes OU (drains réunis des transistors MNOS).

De même qu'on choisit d'effectuer en deux temps l'introduction des instructions de programmation de la matrice OU sur les sorties Si, adresses du décodeur puis données d'écriture, on introduit aussi en deux temps les données d'écriture de la matrice ET. Ceci a déjà été expliqué dans le préambule de la demande de brevet: pendant que l'on met et garde en mémoire l'adressage du décodeur, désignant ainsi la colonne de transistors formant une porte ET à laquelle on s'intéresse, on introduit sur les entrées Ai (Ao à An-1) du réseau une information de désignation de ceux des transistors de la colonne qui doivent être «piégés» (bloquées en permanence). Comme il y a pour chaque entrée Ai trois types de cas possibles selon le produit intermédiaire à réaliser (présence de $a_i$ dans le produit, présence de $\bar{a}_i$, absence de $a_i$ et de $\bar{a}_i$), une seule information binaire est insuffisante; on introduit donc deux informations successives simultanément sur toutes les entrées Ai, soit deux vecteurs d'écriture successifs; ils sont introduits respectivement dans le premier temps et le deuxième temps d'écriture définis pour l'écriture de la matrice OU par les sorties Si.

Les vecteurs d'écriture sont introduits et gardés en mémoire dans des circuits d'interface d'entrée (70) qui effectuent, en mode d'écriture et d'ailleurs aussi en mode de test, un décodage des deux bits d'information introduits sur chaque entrée de variable Ai pour désigner celle des deux lignes de grilles de MNOS correspondant à Ai qui est à programmer ou à tester.

Pour l'opérateur, le travail de programmation est simple et la programmation des matrices ET et OU est simultanée. Elle se fait étape par étape, chaque étape correspondant à un produit intermédiaire à réaliser donc à une colonne de drains de transistors en parallèle pour la matrice ET et à une ligne de grilles en parallèle pour la matrice OU.

L'opérateur choisit dans les combinaisons logiques à réaliser un produit intermédiaire. Il lui affecte une colonne particulière de la matrice ET; il détermine l'adresse de cette colonne à introduire sur les entrées Si dans le premier temps de l'étape d'écriture; il examine dans quelles combinaisons logiques de sortie doit apparaître ce produit intermédiaire (programmation de la matrice OU); il détermine le vecteur d'écriture de matrice OU à introduire pour cela sur les sorties Si dans le deuxième temps de l'étape; ce vecteur s'écrit de manière extrêmement simple: on introduit un 1 logique sur Si si la combinaison logique de sortie sur Si doit comprendre le produit intermédiaire, sinon on introduit un zéro. Dans le même temps, le programmateur examine quels sont les variables ou leurs compléments contenus dans le produit intermédiaire (programmation de la matrice ET); la correspondance entre ces variables et les vecteurs à appliquer aux entrées Ai est encore très directe:

– si la variable $a_i$ apparaît dans le produit intermédiaire on inscrit un 1 logique dans le premier temps de l'écriture puis encore un 1 logique dans le deuxième temps;
– si c'est le complément $\bar{a}_i$ qui apparaît, on inscrit d'abord un 0 puis encore un 0
– si la variable $a_i$ n'apparaît pas du tout, on inscrit d'abord un 1 puis un 0.

En faisant cela pour toutes les variables $a_i$, on obtient deux vecteurs d'écriture successifs qui se résument ainsi:

| | élément de vecteur 1 | élément de vecteur 2 |
|---|---|---|
| occurrence de $a_i$ | 1 | 1 |
| occurrence de $\bar{a}_i$ | 0 | 0 |
| non occurrence de $a_i$ et $\bar{a}_i$ | 1 | 0 |

Ce code est très simple mnémotechniquement pour l'opérateur. On pourrait en utiliser un autre légèrement différent sans sortir du cadre de l'invention.

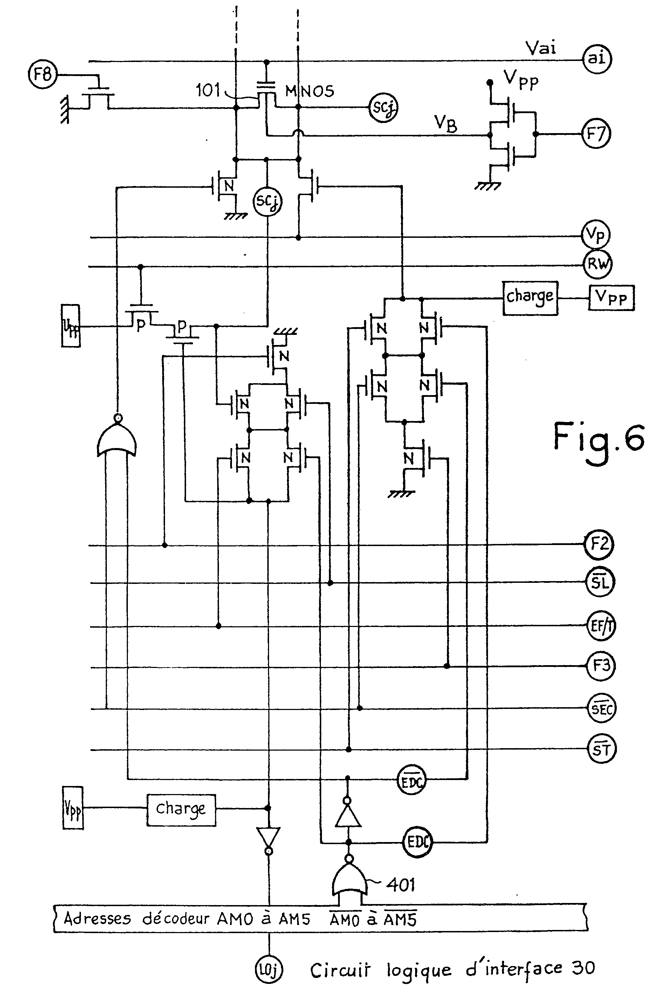

Pour terminer la description de la fig. 4, on indiquera la présence d'un circuit logique de commande (80) qui reçoit des informations ou des niveaux de tension de fonctionnement de l'extérieur pour définir le mode de travail et les instants de déclenchement de cycles d'écriture ainsi que la synchronisation des inscriptions des données en mode de programmation et test. Ce circuit logique, mieux symbolisé à la fig. 5, établit des signaux de commande fonctionnels transmis aux divers circuits logiques d'interface (30, 60, 70), aux commandes de troisième état des amplificateurs tampons etc.

Ce circuit logique de commande (80) a en particulier des fonctions de conversion de niveaux de tension lorsque cela est nécessaire, y compris pour réaliser un interface de compatibilité entre des circuits de technologies différentes.

On remarquera sur la fig. 4 une sortie TM en aval d'un amplificateur à trois états (90). Il s'agit d'une sortie de test permettant d'examiner, en mode de test, la sortie de chacune des colonnes de transistors de la matrice ET, pour déterminer si l'application d'un vecteur logique donné sur les entrées Ai provoque sur chaque sortie de porte ET (choisie par le décodeur) le résultat logique escompté.

Pour préciser les opérations de test, qui s'accomplissent de manière analogue à celles de l'écriture, et pour les deux matrices à la fois, on peut dire que l'opérateur introduit des signaux de test sur les entrées Ai, soit sur une entrée à la fois, soit par vecteurs. Ces vecteurs sont introduits en deux temps et ils désignent les lignes d'entrée de la matrice ET que l'on examine. Pendant ce temps, une adresse de produit intermédiaire donné (donc une colonne de la matrice ET et une ligne d'entrée de la matrice OU) est introduite sur les sorties Si (premier temps de l'étape de test). Puis cette adresse étant mémorisée, les sorties Si servent à nouveau de sorties et non plus d'entrées et fournissent les résultats du test: un 1 sur Si signifie que le produit intermédiaire désigné apparaîtra sur la sortie Si en lecture; un 0 indique qu'il n'apparaîtra pas. La signification du résultat du test de la matrice OU est donc immédiate. Pour la matrice ET, la signification est aussi simple: un signal de test particulier (1,1 ou 0,0) appliqué à une entrée Ai fait apparaître sur la sortie de test TM un 1 ou un zéro selon que la variable $a_i$ apparaît, complémentée ou non dans le produit intermédiaire désigné.

La fig. 5 montre symboliquement le circuit logique de commande qui reçoit

– une tension d'alimentation normale pour circuits MOS complémentaires, Vcc = 5 volts environ
– une tension d'alimentation Vpp qui, si elle est de 5 volts définit le mode de lecture ou de test et si elle est de 25 volts définit le mode d'écriture ou d'effacement
– un signal CE d'autorisation de fonctionnement du circuit servant principalement à déclencher chaque étape de fonctionnement (par exemple chaque étape d'écriture d'un produit intermédiaire)
– un signal VA servant au déclenchement de l'introduction de données d'écriture ou de test sur Ai et Si; couplé à CE, il divise les étapes d'écriture en deux temps; il agit sur les circuits d'interface d'entrée et sortie
– un signal EF/T qui définit le début d'un cycle d'effacement ou de test selon le niveau Vpp.

A partir de ces informations d'entrée, le circuit de commande (80) établit divers signaux de commande appliqués aux circuits d'interfaces pour faire appliquer aux transistors des deux matrices les conditions d'effacement, d'écriture, de test, ou de lecture.

Les signaux de sortie du circuit de commande (80) sont:

– les signaux CE et EF/T eux-mêmes, éventuellement rendus compatibles, s'ils ne l'étaient pas, avec le reste du circuit;
– une tension d'alimentation VIDD qui, en dehors de l'instant d'écriture proprement dite est égale à Vcc et qui devient Vpp à l'instant d'écriture. Cette tension VIDD alimente certains circuits qui ne sont pas alimentés directement par Vcc ou Vpp;
– un signal VA1 et un signal VA2 qui le suit, ces signaux définissant à partir de VA et CE les deux temps d'introduction de données de programmation sur les entrées Ai et les sorties Si en mode d'écriture ou de test;
– un signal RW qui détecte sur Vpp si on est en présence d'une tension faible (0 à 5 volts) ou élevée (25 volts) pour interdire tout passage en mode lecture ou test si la tension est élevée (risque de destruction de l'état programmé des transistors), et pour n'autoriser que le passage en conditions d'effacement ou écriture;
– quatre signaux SL, ST, SEC, SEF définissant à partir de EF/T et RW respectivement les modes de lecture, test, écriture, effacement;
– huit signaux F1 à F8 définissant des états distincts utiles pour la commande des divers circuits; ils sont respectivement:

– F1: fonction indiquant qu'on n'est ni en écriture, ni en test
– F2: on n'est ni en mode d'effacement, ni à l'instant d'écriture proprement dite (défini par SEC et CE)
– F3: on est en mode d'effacement ou en cours de lecture
– F4: on est en cours d'écriture proprement dite
– F5: on est en mode d'effacement ou en cours de test
– F6: on est en cours de test
– F7: on n'est pas en cours d'effacement
– F8: niveau déclenché par RW ou $\overline{CE}$

La réalisation des diverses fonctions du circuit de commande (80) est une pure affaire de logique combinatoire, et d'utilisation d'amplificateurs tampons (buffers) lorsqu'il s'agit de faire des conversions de niveaux logiques de tension. Il n'est pas nécessaire de donner les détails des schémas de portes logiques établissant chaque fonction de commande.

On a donné aux fig. 6 à 10 les schémas complets d'un exemple de réalisation préférentiel des divers autres circuits du réseau programmable, et notamment les circuits d'interface (30, 60 et 70). Ces schémas sont facilement compréhensibles par un homme du métier, compte tenu des explications qui vont suivre et on n'en effectuera pas une explicitation dans les moindres détails.

Tout d'abord, la fig. 6 représente le circuit logique (30) d'interface de liaison entre matrices avec le décodeur (40), ceci au niveau d'une seule colonne j de transistors MNOS de la matrice ET; on n'a représenté qu'un seul transistor MNOS 101 de la matrice ET, celui dont la grille doit recevoir une haute tension de piégeage si la variable $a_i$ doit apparaître dans le produit intermédiaire correspondant à la colonne j considérée.

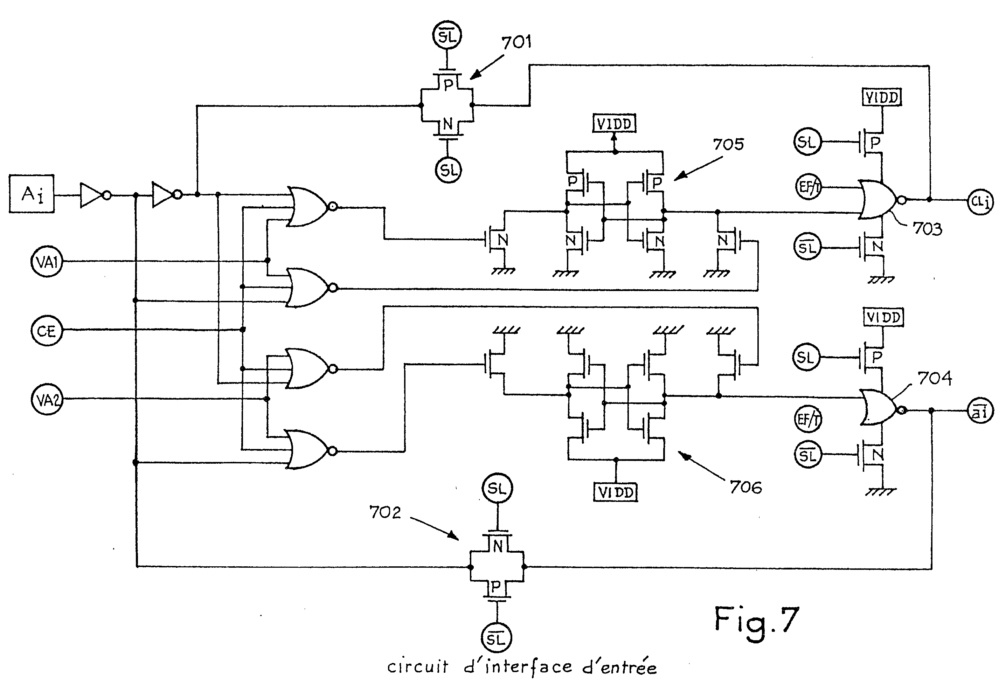

Ce transistor 101 reçoit sur sa grille une tension Vai qui peut être nulle ou de 5 volts ou de 25 volts. (Voir fig. 7 pour la production de cette tension par le circuit d'interface d'entrée 70.)

La source peut être mise à la masse ou en l'air selon l'état de la fonction F8.

Le drain correspond à la sortie SCj de colonne ET (en fait NOR), et il peut être relié à une charge alimentée par Vpp (en lecture), ou mis en l'air (effacement) ou mis à une tension de protection Vp (écriture lorsque la colonne n'est pas sélectionnée), ou enfin mis à zéro (écriture lorsque la colonne j est sélectionnée).

On rappelle que la sélection de colonne se fait par le décodeur dont la porte NOR correspondant à la colonne j est représentée sous la référence 401.

Enfin, le substrat du transistor MNOS peut être mis à 0 volt ou à Vpp selon l'état de la fonction F7.

Les diverses portes de la logique d'interface de la fig. 6 ont été représentées en détail pour montrer comment elles établissent les divers niveaux de tension ou d'impédance aux bornes du transistor MNOS de la ligne i et de la colonne j à partir de l'état de sortie de la porte j du décodeur et des diverses sorties du circuit logique de commande.

Le circuit logique d'interface (30) impose aussi une tension de sortie déterminée sur le conducteur LOj qui est la ligne d'entrée j de la matrice OU (entrée sur une grille de transistor MNOS). En lecture, le signal sur LOj est le même que SCj; c'est d'ailleurs le seul cas où on a une transmission directe entre la matrice ET et la matrice OU.

En dehors de la lecture on peut être en position d'effacement, et une tension nulle apparaît sur LOj; ou en mode d'écriture et la tension apparaissant sur LOj est haute si le décodeur a sélectionné la colonne ou basse si le décodeur ne l'a pas sélectionnée; ou en mode de test et LOj = Vcc ou 0 volt selon que le décodeur a ou non sélectionné la colonne.

La ligne Vp sert à la fois à amener une tension de protection en écriture ou effacement (voir fig. 10), et aussi à recueillir l'état de SCj (isolé de LOj à ce moment là) en mode de test.

La fig. 7 (schéma d'un circuit d'interface d'entrée 70) montre comment on produit la tension adéquate sur les lignes d'entrée $a_i$, $\bar{a}_i$ aboutissant aux grilles des transistors MNOS de la matrice ET; le schéma est un exemple de réalisation utilisant le signal SL (mode de lecture) pour relier par l'intermédiaire de portes de transfert 701 et 702 l'entrée Ai à la ligne $a_i$ et, avec un inverseur, à la ligne $\bar{a}_i$. En dehors du mode de lecture, le signal EF/T est appliqué à deux portes 703 et 704 capables de transmettre la tension VIDD sur les lignes $a_i$ et $\bar{a}_i$.

En effacement, une tension nulle est appliquée aux lignes de grille $a_i$ et $\bar{a}_i$; en test et en écriture, la tension appliquée dépend du signal logique appliqué à l'entrée Ai.

Dans les deux cas, test ou écriture, l'introduction d'une donnée se fait en deux temps et le circuit d'interface d'entrée reçoit d'abord un premier bit d'information pendant la durée du signal VA1 (lui-même contenu dans la durée CE); ce bit est transmis par l'amplificateur tampon de verrouillage 705 et la porte 703, à la ligne $a_i$; si on est en test, ce bit est transmis sous forme d'une tension de 5 volts (VIDD = Vcc) ou zéro; si on est en écriture, il s'agit d'une tension de 25 volts (VIDD = Vpp = 25 volts) ou zéro.

Quand le signal VA1 s'arrête, l'amplificateur tampon de verrouillage 705 ne change pas d'état et la tension en $a_i$ reste inchangée.

Le signal VA2 commence alors, en même temps qu'est chargé à l'entrée Ai un deuxième bit d'information de test ou d'écriture, qui est transmis sous forme complémentée, par un autre amplificateur tampon de verrouillage 706 qui joue aussi le rôle d'inverseur et par la porte 704, à la ligne $\bar{a}_i$. En test, un 1 sur Ai amène 0 volt sur $\bar{a}_i$ tandis qu'un zéro amène 5 volts. En écriture, un 1 sur Ai amène 0 volt sur $\bar{a}_i$ tandis qu'un zéro amène 25 volts.

On comprend donc qu'avec le codage très simple d'écriture ou de test, en deux bits chargés successivement et verrouillés, on peut appliquer indépendamment sur $a_i$ et $\bar{a}_i$, par une seule entrée Ai, les conditions de piégeage ou non piégeage de l'un ou l'autre ou les deux transistors MNOS couplés à $a_i$ et $\bar{a}_i$. En effet, l'introduction successive des bits 1,1 sur Ai amène une tension sur $a_i$ et pas sur $\bar{a}_i$ à la fin de VA1 et VA2; l'introduction de 0,0 amène une tension sur $\bar{a}_i$ et pas sur $a_i$; l'introduction de 1,0 amène une tension à la fois sur $a_i$ et sur $\bar{a}_i$ et les deux transistors correspondant sont piégés.

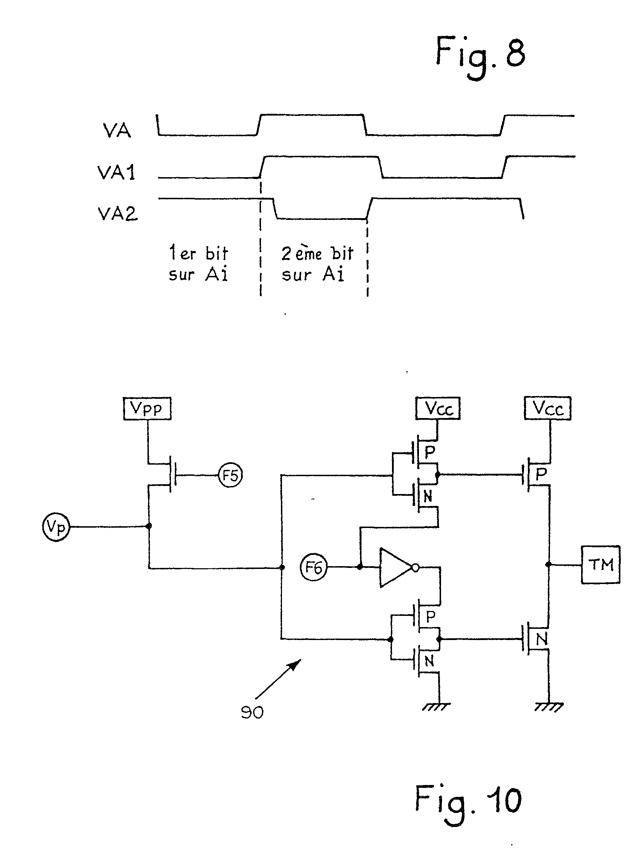

On a représenté à la fig. 8 comment se situent les signaux VA1 et VA2 par rapport au signal VA de chargement qui les engendre, l'introduction du premier bit d'information sur les entrées Ai se faisant pendant que VA1 = 0 et l'introduction du second pendant que VA2 = 0.

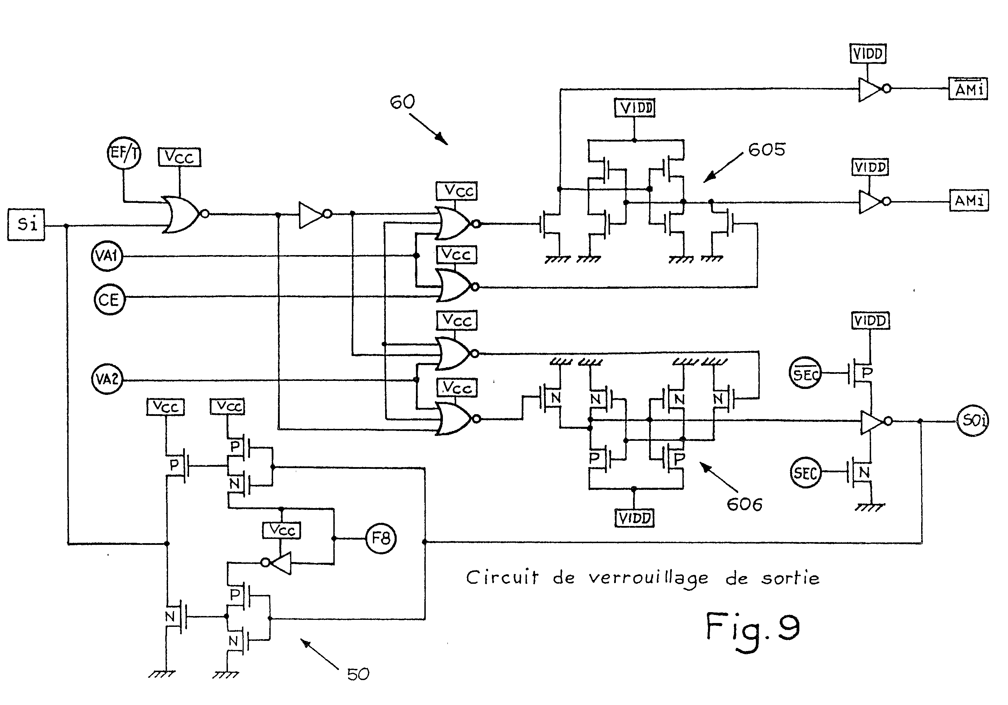

La fig. 9 montre un exemple de réalisation d'un circuit d'interface de sortie (60) permettant de recevoir une adresse de décodeur ou des données d'écriture de la matrice OU à partir des sorties Si du réseau; le schéma de l'amplificateur trois états (50) permettant d'utiliser les sorties Si aussi bien en sorties reliées aux sorties SOi de la matrice OU qu'en entrées d'adressage ou en entrées de données, est aussi figuré sur le dessin de la fig. 9.

Le circuit 60 est tout à fait analogue à celui de la fig. 7, commandé par VA1 et VA2 avec deux amplificateurs tampons 605 et 606 dirigeant les bits d'entrée sur Si respectivement vers les lignes d'adresses de décodeur (AMi et $\overline{AMi}$) pendant que VA1 = 0, et vers les colonnes de sortie SOi de la matrice OU pendant que VA2 = 0. A la fin des deux temps de l'écriture, on a donc un signal d'adressage conservé en mémoire sur AMi et $\overline{AMi}$, désignant un produit intermédiaire donné qui est appliqué (voir fig. 6) sur les lignes d'entrée de la matrice OU (LOj), et une tension d'écriture VIDD ou zéro sur les colonnes SOi.

Cette tension d'écriture va sur les drains des transistors. Par conséquent elle est égale à 0 volt si le transistor doit être piégé (absence du produit intermédiaire désigné par le décodeur dans la combinaison logique à produire sur Si), ou bien elle est égale à VIDD = 25 volts (ou une tension de protection Vp légèrement inférieure) si le produit intermédiaire doit apparaître et que par conséquent le transistor correspondant ne doit pas être piégé.

On fera dans le deuxième temps VA2 de l'écriture Si = 1 donc SOi = 0 volt si le produit intermédiaire doit apparaître; sinon, Si = 0 donc SOi = 25 volts.

La validation de cette inscription se fait par le signal SEC (de mode d'écriture) qui autorise l'application de VIDD ou 0 à SOi.

La sorite SOi est par ailleurs reliée, en vue de la lecture ou du test, à Si par l'intermédiaire de l'amplificateur trois états 50, commandé par le signal F8, qui empêche le retour direct, en écriture ou dans le premier temps du test du signal de Si vers les colonnes SOi.

La fig. 10 montre l'amplificateur à trois états 90 de la fig. 4. Il a deux fonctions:

1. transmettre en mode de test, l'état de la sortie de colonne SCj (matrice ET) désigné par le décodeur (voir fig. 6); cette transmission se fait par la ligne VP et l'amplificateur 90 l'amène à une borne extérieure de test TM sous l'autorisation de la fonction de commande F6 indiquant qu'on est en mode de test.

2. établir une tension de protection Vp qui peut être égale à Vpp vers les drains des colonnes SCj de la matrice ET non sélectionnées par le décodeur, en mode d'écriture.

Pour terminer cette description, on peut encore mentionner que l'information en deux vecteurs introduite sur les entrées Ai en mode de programmation, dont on a dit qu'elle permettait de définir trois états de programmation, permet en réalité d'introduire un quatrième état (deux bits = quatre états possibles). Ce quatrième état, qui serait déterminé par l'introduction d'un 0 puis d'un 1 sur Ai indiquerait la présence à la fois de $a_i$ et $\bar{a}_i$ dans un produit intermédiaire, ce qui annulerait ce dernier. Cet état peut servir de neutralisation des produits intermédiaires non désirés.

Enfin, la description qui précède a été faite à propos de transistors MNOS. D'autres transistors programmables et effaçables électriquement peuvent être utilisés (transistors à grille flottante par exemple).

**Revendications**

1. Réseau logique programmable électriquement, comprenant n entrées de variables (Ai), m sorties de combinaisons logiques (Si) et p colonnes de produits intermédiaires, avec une matrice produit programmable (10) pour effectuer des produits intermédiaires des variables, et une matrice somme programmable (20) pour effectuer des sommes des produtis intermédiaires, caractérisé par le fait qu'il comprend un décodeur (40) capable de désigner individuellement chacune des colonnes de sortie de la matrice produit ainsi qu'une ligne d'entrée de la matrice somme correspondant au même produit intermédiaire que la colonne désignée, un circuit logique (30) d'interface de liaison entre lesdites matrices apte à engendrer, à partir du signal de sortie du décodeur et de signaux de commande d'écriture d'un circuit de commande (80), des signaux de programmation de la colonne désignée et de la ligne correspondante de la matrice somme, le réseau comprenant encore un circuit d'interface d'entrée (70) pour engendrer, à partir de signaux d'écriture appliqués sur les entrées de variable et des signaux de commande d'écriture du circuit de commande, des signaux de programmation de lignes de la matrice produit, ces signaux étant tels que le produit intermédiaire obtenu en sortie de la colonne désignée en mode de lecture, après programmation par les signaux de programmation de lignes et de colonne, soit un produit des variables correspondant aux entrées de variables sur lesquelles on a appliqué un signal d'écriture particulier.

2. Réseau logique selon la revendication 1, caractérisé par le fait qu'il comprend en outre un circuit d'interface de sortie (60) apte à engendrer, à partir de signaux d'écriture appliqués aux sorties du réseau utilisées comme entrées et de signaux de commande d'écriture du circuit de commande, des signaux de programmation des colonnes de la matrice somme, ces signaux étant tels que le produit intermédiaire désigné par le décodeur apparaisse en mode de lecture sur celles des sorties sur lesquelles on a appliqué un signal d'écriture particulier lors de la programmation.

3. Réseau logique selon l'une des revendications 1 et 2, caractérisé par le fait que plusieurs broches de connexion extérieure du réseau, différentes des broches d'entrées de variable, servent d'entrées d'adressage du décodeur pour déterminer le produit intermédiaire à désigner lors d'une étape de programmation.

4. Réseau logique selon la revendication 3, caractérisé par le fait que les entrées d'adressage sont prises parmi les sorties du réseau, le circuit d'interface de sortie ayant en plus une fonction de verrouillage de données pour autoriser l'introduction d'une information d'adressage du décodeur sur ces sorties pendant un premier temps d'une étape de programmation et la conservation en mémoire de cette information pendant un deuxième temps au cours duquel ou bien des signaux d'écriture particuliers sont appliqués sur les sorties du réseau utilisées comme entrées de données de programmation, ou bien des signaux de résultat de test sont lus sur ces sorties.

5. Réseau logique selon l'une des revendications 1 à 4, caractérisé par le fait que le signal d'écriture particulier appliqué aux entrées de variable comprend deux parties introduites successivement, respectivement dans un premier temps et un deuxième temps d'une étape de programmation, le circuit d'interface d'entrée étant apte à utiliser les deux informations successives apparaissant à chaque entrée de variable pour engendrer des signaux de programmation respectifs différents selon que la variable considérée doit apparaître dans le produit intermédiaire désigné, que son complément doit apparaître, ou que ni elle ni son complément ne doivent apparaître.

6. Réseau logique selon la revendication 5, caractérisé par le fait que le circuit d'interface d'entrée est apte à aiguiller la première partie du signal d'écriture appliqué à une entrée de variable vers une ligne d'entrée de la matrice produit correspondant à cette variable, et à aiguiller la seconde partie vers la ligne d'entrée correspondant au complément de cette variable.

7. Réseau logique selon la revendication 6, caractérisé par le fait que le signal d'écriture à appliquer à une entrée de variable est un signal à deux bits logiques qui sont deux 1 successifs si la variable doit apparaître dans le produit intermédiaire désigné, deux 0 successifs si la variable doit apparaître complémentée, et une fois 1 et une fois un 0 si la variable ne doit pas apparaître du tout.

8. Réseau logique selon l'une des revendications 1 à 6, caractérisé par le fait que des amplificateurs à trois états, dont le troisième état est commandé par le circuit de commande, sont interposés entre chaque colonne de sortie de la matrice somme et la sortie correspondante du réseau, pour permettre l'utilisation de ces sorties également en entrées d'adressage ou de signaux d'écriture.

9. Réseau logique selon l'une des revendications 1 à 8, caractérisé par le fait que le circuit logique d'interface de liaison entre matrices est apte à engendrer, à partir du signal de sortie du décodeur désignant un produit intermédiaire particulier et de signaux de commande de test venant du circuit de commande, un signal de résultat de test du produit intermédiaire désigné, ce signal étant transmis à une sortie de lecture de test.

10. Réseau logique selon la revendication 9, caractérisé par le fait que le circuit d'interface d'entrée est apte à engendrer, à partir de signaux de test appliqués sur les entrées de variable et de signaux de commande de test du circuit de commande, des signaux de test de lignes de la matrice produit, appliqués aux lignes d'entrée de la matrice produit de telle manière qu'il y ait correspondance directe entre l'application d'un signal de test particulier sur chaque entrée de variable et l'application d'un signal de test de ligne sur une ligne de la matrice produit correspondant à cette variable.

11. Réseau logique selon la revendication 10, caractérisé par le fait que le circuit d'interface d'entrée est agencé pour produire un signal de test de ligne sur une ligne correspondant à une variable lorsque l'entrée relative à cette variable reçoit successivement deux niveaux logiques 1, pour produire un signal de test de ligne sur une ligne correspondant au complément de la variable lorsque l'entrée relative à cette variable reçoit successivement deux niveaux logiques zéro, et pour produire un signal de test de ligne simultanément sur les lignes correspondant à la variable et à son complément lorsque l'entrée relative à cette variable reçoit successivement un 1 et un zéro.

12. Réseau logique selon l'une des revendications 9 à 11 prises dépendantes de la revendication 3, caractérisé par le fait que le circuit d'interface de liaison est apte à engendrer, à partir du signal de sortie du décodeur désignant une ligne d'entrée de la matrice somme et de signaux de commande de test venant du circuit de commande, un signal de test de ligne appliqué à la ligne d'entrée de matrice somme désignée par le décodeur, les sorties du réseau fournissant le résultat du test avec une correspondance directe entre le résultat obtenu sur chaque sortie et la présence effective du produit intermédiaire désigné dans la combinaison logique programmée sur la colonne de matrice somme correspondant à cette sortie.

13. Réseau logique programmable selon la revendication 12, caractérisé par le fait que le circuit d'interface de sortie est apte à recevoir une information d'adressage du décodeur dans un premier temps d'une étape de test, à garder cette information en mémoire, et, à partir de cette information et de signaux de commande de test du circuit de commande, à engendrer sur chaque sortie du réseau un niveau logique 1 si le produit intermédiaire désigné par le décodeur figure bien dans la combinaison logique programmée sur cette sortie, et un niveau logique 0 dans le cas contraire.

14. Réseau logique selon l'une des revendications 1 à 13, caractérisé par le fait que le circuit d'interface de liaison entre matrices est apte, en réponse à des signaux de commande de lecture du circuit de commande, à transmettre aux lignes d'entrée de la matrice somme les signaux de sortie de la matrice produit, et que le circuit d'interface d'entrée est apte, en réponse aux mêmes signaux de commande à transmettre aux linges d'entrée de la matrice produit les signaux logiques appliqués aux entrées de variables ainsi que les compléments de ces signaux logiques.

15. Réseau logique selon l'une des revendications 1 à 14, caractérisé par le fait que le décodeur est constitué de p portes à $2^r$ entrées logiques et r inverseurs, avec $2^{r-1} < p \leq 2^r$, les portes étant programmées de manière que le décodeur fournisse un niveau logique parmi p.

16. Réseau logique selon l'une des revendications 1 à 15, caractérisé par le fait que la matrice produit et/ou la matrice somme sont réalisées à partir d'une série de p (respectivement m) portes NOR à 2n (respectivement p) entrées.

17. Réseau logique selon la revendication 16, caractérisé par le fait que chaque porte NOR comprend une série de 2n (respectivement p) transistors MNOS en parallèle, les entrées de portes étant prises sur les grilles, ces transistors pouvant être rendus bloqués de manière permanente par application d'une tension supérieure à la normale sur la grille et la programmation des matrices ayant lieu par application de cette haute tension sur des transistors choisis.

18. Réseau logique selon la revendication 17, caractérisé par le fait que les circuits d'interface sont aptes à appliquer aux diverses électrodes des transistors (grilles, sources, drains, substrats), sous la commande du circuit de commande et des entrées du réseau, une tension nulle, ou normale, ou élevée, ou un état haute impédance.

19. Réseau logique selon l'une des revendications 17 et 18, caractérisé par le fait que les transistors sont à canal N, que leurs sources sont reliées entre elles par colonnes de matrice, que leurs drains sont reliés entre eux par colonnes, que leurs grilles sont reliés entre elles par lignes, et que tous les substrats sont reliés entre eux et à un conducteur de commande de la tension de substrat.

20. Réseau logique programmable selon la revendication 19, caractérisé par le fait que les circuits d'interface sont aptes à appliquer, selon les signaux de commande du circuit de commande, les configurations de tensions suivantes:

a) sources à 0 volt, drains reliés par une charge à une tension normale, substrat à 0 volt, grille à tension normale ou nulle selon le signal reçu,
b) sources déconnectés, drains déconnectés, grilles à 0 volt, substrat à haute tension,
c) sources déconnectés, drains à 0 volt, substrat à 0 volt, grilles à haute tension ou à 0 volt selon le signal reçu,
d) sources déconnectés, drains à haute tension, substrat à 0 volt, grilles à haute tension ou 0 volt.

**Claims**

1. Electrically programmable logic network comprising n variable inputs (Ai), m logic combination outputs (Si) and p intermediate product columns, having a programmable product matrix (10) for forming intermediate products of the variables, and a programmable sum matrix (20) for forming the sums of the intermediate products, characterized in that it includes a decoder (40) capable of designating individually each of the output columns of the product matrix as well as an input line of the sum matrix corresponding to the same intermediate product as the designated column, a logic interface connection circuit (30) between said matrices adapted to generate from the output signal of the decoder and the write control signals of a control circuit (80) signals for programming the column designated and the corresponding line of the sum matrix, the network also including an input interface circuit (70) for generating from write signals applied to the variable inputs and from the write control signals of the control circuit signals for programming lines of the product matrix, said signals being such that the intermediate product obtained at the output of the designated column in the read mode, after programming by the line and column programming signals is a product of variables which corresponds to the variable inputs to which a particular write signal has been applied.

2. Logic network according to Claim 1, characterized in that it further includes an output interface circuit (60) which is adapted to generate from write signals applied to the network outputs used as inputs and from write control signals of the control circuit programming signals for programming the columns of the sum matrix, said signals being such that the intermediate product designated by the decoder appears in reading mode at those outputs to which a particular write signal has been applied during the programming.

3. Logic network according to one of Claims 1 and 2, characterized in that a plurality of connection pins outside the network, different from the variable input pins, serve as address inputs of the decoder for determining the intermediate product to be designated during a programming step.

4. Logic network according to Claim 3, characterized in that the address inputs are among the network outputs, the output interface circuit having in addition a data latching function for authorizing the introduction of a decoder addressing information at said outputs during a first time of a programming step and the retaining in a memory of said information during a second time during which either particular write signals are applied to the network outputs used as programming data inputs or test result signals are read at said outputs.

5. Logic network according to one of Claims 1 to 4, characterized in that the particular write signal applied to the variable inputs comprises two parts introduced successively, in a first time and a second time of a programming step respectively, the input interface circuit being adapted to use the two successive informations appearing at each variable input to generate respective programming signals different according to whether the variable considered is to appear in the intermediate designated product, its complement is to appear, or neither it nor its complement is to appear.

6. Logic network according to Claim 5, characterized in that the input interface circuit is adapted to direct the first part of the write signal applied to a variable input to an input line of the product matrix corresponding to said variable, and to direct the second part to the input line corresponding to the complement of said variable.

7. Logic network according to Claim 6, characterized in that the write signal to be applied to a variable input is a logic two-bit signal which are two successive 1's if the variable is to appear in the designated intermediate product, two successive 0's if the complement of the variable is to appear and one 1 and one 0 if the variable is not to appear at all.

8. Logic network according to one of Claims 1 to 6, characterized in that tri-state amplifiers of which the third state is controlled by the control circuit are interposed between each output column of the sum matrix and the corresponding output of the network in order to permit utilization of said outputs equally as address inputs or write signal inputs.

9. Logic network according to one of Claims 1 to 8, characterized in that the logic connection interface circuit between the matrices is adapted to produce from the output signal of the decoder designating a particular intermediate product and from test control signals coming from the control circuit a test result signal of the designated intermediate product, said signal being transmitted to a test read output.

10. Logic network according to Claim 9, characterized in that the input interface circuit is adapted to produce from test signals applied to the variable inputs and from test control signals of the control circuit line test signals of the product matrix which are applied to input lines of the product matrix in such a manner that there is a direct correspondence between the application of a particular test signal to each variable input and the application of a line test signal to a line of the product matrix corresponding to said variable.

11. Logic network according to Claim 10, characterized in that the input interface circuit is designed to produce a line test signal on a line corresponding to a variable when the input belonging to said variable successively receives two logic levels 1, to produce a line test signal on a line corresponding to the complement of the variable when the input belonging to said variable receives successively two logic levels zero, and to produce a line test signal simultaneously on the lines which corresponds to the variable and its complement when the input belonging to said variable receives successively a 1 and a zero.

12. Logic network according to one of Claims 9 to 11 taken in dependence upon Claim 3, characterized in that the connection interface circuit is adapted to produce from the output signal of the decoder designating an input line of the sum matrix and from test control signals coming from the control circuit a line test signal applied to the input line of the sum matrix designated by the decoder, the outputs of the network supplying the test result with a direct correspondence between the result obtained at each output and the effective presence of the intermediate product designated in the logic combination programmed at the sum matrix column corresponding to said output.

13. Programmable logic network according to Claim 12, characterized in that the output interface circuit is adapted to receive an address information of the decoder in a first time of a test step, to keep said information stored, and from said information and test control signals of the control circuit to produce at each output of the network a logic level 1 if the intermediate product designated by the decoder appears in the logic combination programmed at said output, and a logic level 0 in the contrary case.

14. Logic network according to one of Claims 1 to 13, characterized in that the connection interface circuit between the matrices is adapted in response to read control signals of the control circuit to transmit to the input lines of the sum matrix the output signals of the product matrix, and that the input interface circuit is adapted in response to the same control signals to transmit to the input lines of the product matrix the logic signals applied to the variable inputs as well as the complements of said logic signals.

15. Logic network according to one of Claims 1 to 14, characterized in that the decoder is constituted by p gates with $2^r$ logic inputs and r inverters with $2^{r-1} < p \leq 2^r$, the gates being programmed in such a manner that the decoder supplies a logic level from among p.

16. Logic network according to one of Claims 1 to 15, characterized in that the product matrix and/or the sum matrix are formed from a series of p (n, respectively) NOR gates with 2n (p, respectively) inputs.

17. Logic network according to Claim 16, characterized in that each NOR gate comprises a series of 2n (p, respectively) MNOS transistors in parallel, the inputs of the gates being formed at the gates, it being possible to turn off said transistors in permanent manner by application of a voltage greater than the normal to the gate, and the programming of the matrices taking place by application of said high voltage to selected transistors.

18. Logic network according to Claim 17, characterized in that the interface circuits are adapted to apply to the various electrodes of the transistors (gates, sources, drains, substrates), under the control of the control circuit and the inputs of the network, a zero voltage, a normal voltage or a high voltage or a state of high impedance.

19. Logic network according to one of Claims 17 and 18, characterized in that the transistors are of N-channel type, that their sources are connected to each other by matrix columns, that their drains are connected to each other by columns, that their gates are connected to each other by lines, and that all the substrates are connected to each other and to a conductor for control of the substrate voltage.

20. Programmable logic network according to Claim 19, characterized in that the interface circuits are adapted to apply in accordance with the control signals of the control circuit the following voltage configurations:

a) sources at 0 volt, drains connected by a load to a normal voltage, substrate at 0 volt, gate at normal voltage or zero voltage according to the signal received,

b) sources disconnected, drains disconnected, gates at 0 volt, substrate at high voltage,

c) sources disconnected, drains at 0 volt, substrate at 0 volt, gates at high voltage or 0 volt according to the signal received,

d) sources disconnected, drains at high voltage, substrate at 0 volt, gates at high voltage or 0 volt.

## Patentansprüche

1. Elektrisch programmierbares logisches Netzwerk, das n Eingänge (Ai) für variable Grössen, m Ausgänge (Si) für logische Kombinationen und p Zwischenproduktspalten enthält, mit einer programmierbaren Produktmatrix (10) zur Bildung von Zwischenprodukten der Variablen und einer programmierbaren Summenmatrix (20) zur Bildung der Summen der Zwischenprodukte, dadurch gekennzeichnet, dass es einen Decoder (40) umfasst, der imstande ist, individuell jede der Ausgangsspalten der Produktmatrix sowie eine Eingangsleitung der Summenmatrix zu bezeichnen, welche demselben Zwischenprodukt wie die bezeichnete Spalte entspricht, und eine logische Schnittstellen-Verbindungsschaltung (30) zwischen den genannten Matrizen enthält, die geeignet ist, aus dem Ausgangssignal des Decoders und aus Schreibsteuersignalen einer Steuerschaltung (80) Signale zum Programmieren der bezeichneten Spalte und der entsprechenden Zeile der Summenmatrix zu erzeugen, wobei das Netzwerk ferner eine Eingangs-Schnittstellenschaltung (70) umfasst, um aus Schreibsignalen, welche an die Eingänge für die variablen Grössen angelegt sind und aus den Schreibsteuersignalen der Steuerschaltung Programmiersignale zum Programmieren von Zeilen der Produktmatrix zu erzeugen, wobei diese Signale derart sind, dass das Zwischenprodukt, welches am Ausgang der bezeichneten Spalte im Lesebetrieb nach Programmierung durch die Zeilen- und Spalten-Programmiersignale erhalten wird, ein Produkt der Variablen ist, das den variablen Eingängen entspricht, an die ein besonderes Schreibsignal angelegt ist.

2. Logisches Netzwerk nach Anspruch 1, dadurch gekennzeichnet, dass es ferner eine Ausgangs-Schnittstellenschaltung (60) umfasst, die geeignet ist, um aus den Schreibsignalen, die an die als Eingänge verwendeten Ausgänge des Netzwerks angelegt sind, und aus Schreibsteuersignalen der Steuerschaltung Programmiersignale zum Programmieren der Spalten der Summenmatrix zu erzeugen, wobei diese Signale derart sind, dass das durch den Decoder bezeichnete Zwischenprodukt im Lesebetrieb an denjenigen Ausgängen erscheint, an welche während der Programmierung ein besonderes Schreibsignal angelegt wurde.

3. Logisches Netzwerk nach einem der Ansprüche 1 und 2, dadurch gekennzeichnet, dass mehrere Anschlussstifte, die sich ausserhalb des Netzwerks befinden und verschieden von den Variablen-Eingangsstiften sind, als Adressiereingänge des Decoders dienen, um das zu bezeichnende Zwischenprodukt während eines Programmierschrittes zu bestimmen.

4. Logisches Netzwerk nach Anspruch 3, dadurch gekennzeichnet, dass Ausgänge des Netzwerks als Adressiereingänge verwendet sind, wobei die Ausgangs-Schnittstellenschaltung ferner eine Funktion der Verriegelung von Daten hat, um die Eingabe einer Adressierinformation des Decoders an diesen Ausgängen während einer ersten Zeit eines Programmierschrittes und die Bewahrung dieser Information in einem Speicher während einer zweiten Zeit zu gestatten, während welcher entweder besondere Schreibsignale an die als Programmierdaten-Eingänge verwendeten Ausgänge des Netzwerks angelegt werden oder aber Testergebnissignale an diesen Ausgängen abgelesen werden.

5. Logisches Netzwerk nach einem der Ansprüche 1 bis 4, dadurch gekennzeichnet, dass das besondere Schreibsignal, welches an die variablen Eingänge angelegt ist, zwei Teile umfasst, die nacheinander eingegeben werden, der erste während einer ersten Zeit und der zweite während einer zweiten Zeit eines Programmierschrittes, wobei die Eingangs-Schnittstellenschaltung geeignet ist, um die beiden aufeinanderfolgenden Informationen, die an jedem Variableneingang erscheinen, zu verwenden, um Programmiersignale zu erzeugen, die jeweils verschieden sind, je nachdem, ob die betrachtete Variable in dem bezeichneten Zwischenprodukt erscheinen soll, ihr Komplement erscheinen soll oder weder sie noch ihr Komplement erscheinen soll.

6. Logisches Netzwerk nach Anspruch 5, dadurch gekennzeichnet, dass die Eingangs-Schnittstellenschaltung geeignet ist, um den ersten Teil des an einen Variableneingang angelegten Schreibsignals zu einer Eingangszeile der Produktmatrix, welche dieser Variablen entspricht, umzulenken, und den zweiten Teil zu der Eingangszeile umzulenken, welche dem Komplement dieser Variablen entspricht.

7. Logisches Netzwerk nach Anspruch 6, dadurch gekennzeichnet, dass das an einen Variableneingang anzulegende Schreibsignal ein logisches Zweibit-Signal ist, das zwei aufeinanderfolgende Einsen enthält, wenn die Variable in dem bezeichneten Zwischenprodukt erscheinen soll, aus zwei aufeinanderfolgenden Nullen besteht, wenn das Komplement der Variablen erscheinen soll, und aus einer Eins und einer Null besteht, wenn die Variable überhaupt nicht erscheinen soll.

8. Logisches Netzwerk nach einem der Ansprüche 1 bis 6, dadurch gekennzeichnet, dass Drei-Zustands-Verstärker, deren dritter Zustand durch die Steuerschaltung gesteuert wird, zwischen jede Ausgangsspalte der Summenmatrix und den entsprechenden Ausgang des Netzwerks eingefügt sind, um die Verwendung dieser Ausgänge auch als Adressiereingänge oder Schreibsignaleingänge zu ermöglichen.

9. Logisches Netzwerk nach einem der Ansprüche 1 bis 8, dadurch gekennzeichnet, dass die logische Verbindungs-Schnittstellenschaltung zwischen den Matrizen geeignet ist, um aus dem Ausgangssignal des Decoders, der ein besonderes Zwischenprodukt bezeichnet, und aus Teststeuersignalen, die aus der Steuerschaltung stammen, ein Testergebnissignal bezüglich eines Tests des bezeichneten Zwischenproduktes zu erzeugen, wobei dieses Signal zu einem Test-Leseausgang übertragen wird.

10. Logisches Netzwerk nach Anspruch 9, dadurch gekennzeichnet, dass die Eingangs-Schnittstellenschaltung geeignet ist, um aus Testsignalen, die an die Variableneingänge angelegt sind, und aus Teststeuersignalen der Steuerschaltung Zeilen-Testsignale bezüglich der Prüfung der Zeilen der Produktmatrix zu erzeugen, welche an die Eingangszeilen der Produktmatrix angelegt sind, derart, dass eine direkte Entsprechung zwischen dem Anlegen eines besonderen Testsignals an jeden Variableneingang und dem Anlegen eines Zeilen-Testsignals an eine Zeile der Produktmatrix, welche dieser Variablen entspricht, besteht.

11. Logisches Netzwerk nach Anspruch 10, dadurch gekennzeichnet, dass die Eingangs-Schnittstellenschaltung so ausgebildet ist, dass sie ein Zeilen-Testsignal auf einer Zeile erzeugen kann, welche einer Variablen entspricht, wenn der zu dieser Variablen gehörende Eingang nacheinander zwei Logikpegel 1 empfängt, um ein Zeilen-Testsignal auf einer Leitung zu erzeugen, welche dem Komplement der Variablen entspricht, wenn der zu dieser Variablen gehörende Eingang nacheinander zwei Logikpegel 0 empfängt, und um ein Zeilen-Testsignal gleichzeitig auf den Leitungen zu erzeugen, welche der Variablen und ihrem Komplement entsprechen, wenn der zu dieser Variablen gehörende Eingang nacheinander eine Eins und eine Null empfängt.

12. Logisches Netzwerk nach einem der Ansprüche 9 bis 11, in Verbindung mit Anspruch 3, dadurch gekennzeichnet, dass die Verbindungs-Schnittstellenschaltung geeignet ist, um aus dem Ausgangssignal des Decoders, welcher eine Eingangszeile der Summenmatrix bezeichnet, und aus Test-Steuersignalen, die aus der Steuerschaltung stammen, ein Zeilen-Testsignal zu erzeugen, das an die Eingangszeile der durch den Decoder bezeichneten Summenmatrix angelegt ist, wobei die Ausgänge des Netzwerks das Testergebnis liefern, mit einer direkten Entsprechung zwischen dem an jedem Ausgang erhaltenen Ergebnis und der effektiven Anwesenheit des Zwischenproduktes, das in der Logikkombination bezeichnet ist, welche an der diesem Ausgang entsprechenden Summenmatrixspalte programmiert ist.

13. Programmierbares logisches Netzwerk nach Anspruch 12, dadurch gekennzeichnet, dass die Ausgangs-Schnittstellenschaltung geeignet ist, um eine Decoder-Adressierinformation während einer ersten Zeit eines Testschrittes zu empfangen, diese Information gespeichert zu halten und aus dieser Information sowie Test-Steuersignalen aus der Steuerschaltung an jedem Ausgang des Netzwerks einen Logikpegel 1 zu erzeugen, wenn das durch den Decoder bezeichnete Zwischenprodukt in der an diesem Ausgang programmierten Logikkombination in Erscheinung tritt, und andernfalls einen Logikpegel 0 zu erzeugen.

14. Logisches Netzwerk nach einem der Ansprüche 1 bis 13, dadurch gekennzeichnet, dass die Verbindungs-Schnittstellenschaltung zwischen den Matrizen geeignet ist, ansprechend auf Lese-Steuersignale aus der Steuerschaltung zu den Eingangsleitungen der Summenmatrix die Ausgangssignale der Produktmatrix zu übertragen, und dass die Eingangs-Schnittstellenschaltung geeignet ist, um ansprechend auf dieselben Steuersignale zu den Eingangsleitungen der Produktmatrix die Logiksignale, welche an die Variableneingänge angelegt sind, sowie die Komplemente dieser Logiksignale zu übertragen.

15. Logisches Netzwerk nach einem der Ansprüche 1 bis 14, dadurch gekennzeichnet, dass der Decoder aus p Torschaltungen mit $2^r$ Logikeingängen und r Invertern gebildet ist, mit $2^{r-1} < p \leq 2^r$, wobei die Torschaltungen derart programmiert sind, dass der Decoder einen von p Logikpegeln liefert.

16. Logisches Netzwerk nach einem der Ansprüche 1 bis 15, dadurch gekennzeichnet, dass die Produktmatrix und/oder die Summenmatrix aus einer Reihe von p (bzw. n) NOR-Torschaltungen mit 2n (bzw. p) Eingängen gebildet sind.

17. Logisches Netzwerk nach Anspruch 16, dadurch gekennzeichnet, dass jede NOR-Torschaltung eine Reihe von 2n (bzw. p) MNOS-Transistoren umfasst, die parallel liegen, wobei die Eingänge der Torschaltungen an den Gates gebildet sind, wobei diese Transistoren durch Anlegen einer den Normalwert überschreitenden Spannung an das Gate dauerhaft gesperrt werden können und die Programmierung der Matrizen durch Anlegen dieser hohen Spannung an die gewählten Transistoren erfolgt.

18. Logisches Netzwerk nach Anspruch 17, dadurch gekennzeichnet, dass die Schnittstellenschaltungen geeignet sind, um an die verschiedenen Transistorelektroden (Gates, Sources, Drains, Substrate), unter Steuerung durch die Steuerschaltung und die Eingänge des Netzwerks, eine verschwindende Spannung, eine normale Spannung oder eine hohe Spannung oder einen Zustand hoher Impedanz anzulegen.

19. Logisches Netzwerk nach einem der Ansprüche 17 und 18, dadurch gekennzeichnet, dass die Transistoren vom N-Kanal-Typ sind, dass ihre Source-Elektroden untereinander durch Matrixspalten verbunden sind, dass ihre Drain-Elektroden untereinander durch Spalten verbunden sind, dass ihre Gates untereinander durch Zeilen verbunden sind und dass alle Substrate untereinander und mit einem Leiter zur Steuerung der Substratspannung verbunden sind.

20. Programmierbares logisches Netzwerk nach Anspruch 19, dadurch gekennzeichnet, dass die Schnittstellenschaltungen geeignet sind, um je nach den Steuersignalen der Steuerschaltung die folgenden Spannungskonfigurationen anzulegen:

a) Source-Elektroden auf 0 Volt, Drain-Elektroden über eine Belastung an eine normale Spannung angelegt, Substrat auf 0 Volt, Gate auf normaler oder verschwindender Spannung, je nach dem empfangenen Signal,

b) Source-Elektroden abgetrennt, Drain-Elektroden abgetrennt, Gates auf 0 Volt, Substrat auf hoher Spannung,

c) Source-Elektroden abgetrennt, Drain-Elektroden auf 0 Volt, Substrat auf 0 Volt, Gates auf hoher Spannung oder 0 Volt, je nach empfangenem Signal,

d) Source-Elektroden abgetrennt, Drain-Elektroden auf hoher Spannung, Substrat auf 0 Volt, Gates auf hoher Spannung oder 0 Volt.

Fig. 1

Fig.2

Fig.3

Fig. 5

21

mode de fonctionnement

logique de commande

VIDD

~ 80

VIDD

de la logique
de commande

signaux fonctionnels de commande
et tensions d'alimentation

70

$A_0$ — interface
d'entrée

$a_0$

$\bar{a}_0$

$A_1$

$a_1$

$\bar{a}_1$

~ 10

$A_i$ --- VIDD

$a_i$

Matrice ET
produits

( MNOS )

TM

Sortie
test ET

$A_{n-1}$

$a_{n-1}$

$\bar{a}_{n-1}$

90

$3^{ème}$ état

Logique interface
(30)

VIDD

Décodeur 1/p
(40)

interface
de sortie

60

de la logique
de commande

Logique interface
(30)

Matrice OU
sommes

( MNOS )

$SO_0$

50

$3^{ème}$ état

$S_0$

--- $S_i$

$SO_{m-1}$

50

$S_{m-1}$

$3^{ème}$ état

20

# Fig. 4

Fig.6

Adresses décodeur AM0 à AM5 $\overline{AM0}$ à $\overline{AM5}$

Circuit logique d'interface 30

Fig.7

circuit d'interface d'entrée

# Fig. 8

VA

VA1

VA2

1er bit
sur Ai

2ème bit
sur Ai

Vpp

F5

Vp

Vcc

P

N

F6

Vcc

P

P

N

TM

N

90

# Fig. 10

Circuit de verrouillage de sortie

Fig. 9